# EUROPEAN PATENT APPLICATION

(11) **EP 0 740 330 A2**
(43) Date of publication of application: **30.10.1996**
(21) Application number: 96106770.9
(22) Date of filing: 29.04.1996
(51) Int. Cl.: H01L 21/027

(54) **Method for reducing the standing wave effect in a photolithography process**

(30) Priority: 28.04.1995 US 430965
(71) Applicant: TEXAS INSTRUMENTS INCORPORATED, Dallas Texas 75265 (US)
(72) Inventor: Thakar, Guatam V., Plano, TX 75023 (US); Garza, Cesar M., Plano, TX 75023 (US); Chapman, Richard A., Dallas, TX 75240 (US)
(74) Representative: Schwepfinger, Karl-Heinz, Dipl.-Ing.

(57) **Abstract**

A method for reducing the standing wave effects in a photolithography process of a polysilicon layer (106) is described herein. A anti-reflective coating (108), such as titanium nitride, is deposited over the polysilicon layer (106). Photoresist (110) is then deposited over the anti-reflective coating (108) and a portion of the photoresist (110) is exposed using an optical beam (112). The anti-reflective coating (108) absorbs the optical beam (112) reducing the standing wave effects. A portion of the photoresist material (110) is then removed. Portions of the anti-reflective coating (108) and polysilicon layer (106) not covered by photoresist (110) are then etched away creating a polysilicon line having a more uniform linewidth.

## Description

### FIELD OF THE INVENTION

This invention generally relates to semiconductor processing and more specifically to anti-reflective coatings in optical lithography.

### BACKGROUND OF THE INVENTION

In the art of semiconductor processing, optical lithography is used to form patterned geometries such as metal interconnect lines and polysilicon gate electrode lines. As devices become more dense, these lines become narrower. Two problems associated with optical lithography become more pronounced as the lines get narrower. These are reflective notching and standing wave problems. Optical lithography involves placing a photoresist material over a material to be patterned and etched. An optical beam is then passed through a reticle to expose portions of the photoresist in a desired pattern. Then, depending on whether positive or negative photoresist is used, either the exposed photoresist or the unexposed photoresist is removed. An etch is then performed to remove material not covered by photoresist and a patterned geometry is created.

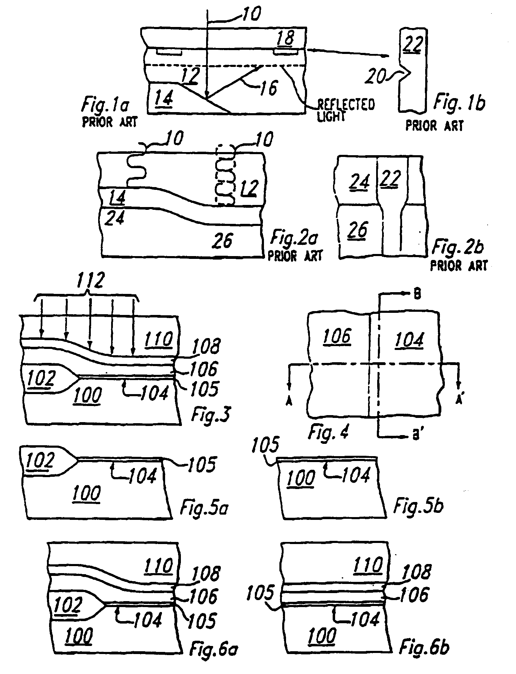

As shown in Figure 1a, reflective notching occurs due to the particle nature of light when the optical beam 10 used for optical lithography passes through the photoresist material 12 and is reflected off the surface of a highly reflective underlying material 14 (e.g., metal). Due to topography changes, the reflection 16 may occur at an angle that exposes photoresist material 12 that should be blocked by the reticle 18. This causes a notch 20 in the resulting interconnect line 22 as shown in Figure 1b.

The standing wave problem is associated with the wave nature of light and is illustrated in Figures 2a-b. The optical beam 10 has a given wavelength. An interference pattern is created between the normally incident light of the optical beam 10 and the light reflected from the surface of the underlying material 14. The underlying material 14 for purposes of standing waves is not necessarily highly reflective and can comprise for example polysilicon. The result is local variations in the effective dose of the optical beam 10 within the photoresist layer 12. The interference pattern is aggravated by a change in topography (such as going from region 24 to 26). Accordingly, the width of the pattern (the exposed portion of the photoresist 12) may vary as the topography changes, causing a variation in line width in the resulting interconnect line 22 or polysilicon gate electrode as shown in Figure 2b.

Organic anti-reflective coatings have been used to overcome the problems of standing waves. The organic anti-reflective coating is applied prior to the deposition of the photoresist material. When the photoresist is exposed to the optical beam, reflection is inhibited by the organic anti-reflective coating. Localized variations in the dose of the optical beam are thus reduced.

### SUMMARY OF THE INVENTION

A method for reducing the standing wave effects in a photolithography process of a polysilicon layer is described herein. An anti-reflective coating containing a metal, such as titanium nitride, is deposited over the polysilicon layer. Photoresist is then deposited over the anti-reflective coating and a portion of the photoresist is exposed using an optical beam. The anti-reflective coating absorbs the optical beam reducing the standing wave effects. A portion of the photoresist material may then be removed. Portions of the anti-reflective coating and polysilicon layer not covered by photoresist may then be etched away creating a polysilicon line having a more uniform linewidth.

An advantage of the invention is providing an improved photolithography method having reduced standing wave effects.

A further advantage of the invention is providing a photolithography process having improved metrology characteristics.

A further advantage of the invention is providing a photolithography process that produces a more uniform linewidth.

### BRIEF DESCRIPTION OF THE DRAWINGS

The present invention will now be further described, by way of example with reference to the accompanying drawings, in which;
FIG. 1a is a cross-sectional view of reflective notching on a prior art semiconductor body undergoing photolithography;
FIG. 1b is a top view of a prior art semiconductor body affected by reflective notching;
FIG. 2a is a cross-sectional view of standing wave effects on a prior art semiconductor body undergoing photolithography;
FIG. 2b is a top view of a prior art semiconductor body affected by standing wave effects;
FIG. 3 is a cross-sectional view of a semiconductor body undergoing photolithography according to the invention;
FIG. 4 is a top view of a semiconductor body of Fig.3 prior to deposition, pattern and etch of polysilicon;
FIG. 5a-b are cross-sectional views of the semiconductor body of FIG. 4 along lines A-A' and B-B' respectively;
FIGs. 6a-10b are cross-sectional views at various steps in a photolithography process on the semiconductor body of FIG. 4 according to the invention, with the "a" figures illustrating a cross-section along line A-A' and the "b" figures illustrating a cross-section along line B-B'; and
FIG. 11 is a top view of the resulting polysilicon line having a uniform line width created using the invention.

Corresponding numerals and symbols in the different figures refer to corresponding parts unless otherwise indicated.

### DETAILED DESCRIPTION OF PREFERRED EMBODIMENTS

The invention relates to a method of reducing the standing wave effects in a photolithography process. By reducing the standing wave effects, a more uniform polysilicon line may be formed even when the polysilicon line extends over uneven topography such as that which occurs in the transition from a field oxide region to a moat region.

Figure 3 illustrates a semiconductor body 100 undergoing a photolithography process according to the invention. Semiconductor body 100 comprises a field oxide region 102 and a moat region 104. Field oxide region 102 isolates moat region 104 from other moat regions not shown. Moat regions are areas in which transistors may subsequently be formed. A layer of polysilicon 106 is located over field oxide region 102 and gate oxide 105. It may, for example, be desired to pattern polysilicon layer 106 to form a polysilicon line that serves as one or more gate electrodes in a semiconductor device such as a memory device.

Located above polysilicon layer 106 is anti-reflective coating 108 comprising a metal. Anti-reflective coating 108 serves to reduce the standing wave effects as will be discussed below. Anti-reflective coating 108 has a thickness in the range of 300-5000Å (angstroms). In the preferred embodiment, titanium nitride having a thickness of the order of 550Å (angstroms) is used for anti-reflective coating 108. Other anti-reflectives comprising a metal having light-absorbing properties in the wavelength of the light used to expose the photoresist may be used as long as contamination at gate level processing is avoided.

A layer of photoresist 110 is located above anti-reflective coating 108. A mask or reticle (not shown) defines the desired pattern and blocks optical beam 112 from selected areas of photoresist layer 110. Anti-reflective coating 108 reduces the standing wave effects of optical beam 112. The interference pattern normally created between the incident optical beam 112 and a reflected beam is reduced due to the properties of the anti-reflective coating 108. Anti-reflective coatings containing metal such as titanium nitride have better anti-reflective properties than prior art organic anti-reflective coatings. They are darker and are better for metrology purposes because they provide a better charge dissipation for the photoresist which eliminates noise on SEMs (scanning electron microscope) pictures. Furthermore, titanium nitride does not pose a contamination problem at gate level processing as might have been expected.

Figure 4 illustrates a top view and Figures 5a-b illustrate a cross-sectional view of semiconductor body 100 having field oxide regions 102 formed therein defining moat regions 104 and gate oxide layer 105. A method of forming a polysilicon line having uniform width over a portion of field oxide regions 102 and moat regions 104 will now be described.

Referring to Figures 6a-b, a layer of polysilicon 106 is deposited over the surface of the structure. The thickness of polysilicon layer 106 varies by design. For example, polysilicon layer may be of the order of 2500Å (angstroms). Next, an anti-reflective layer 108 is deposited over polysilicon layer 106. Anti-reflective layer 108 preferably comprises titanium nitride. However, other anti-reflectives containing a metal may alternatively be used as long as contamination of the structure is avoided and the material absorbs light in the wavelength of the optical beam used to subsequently expose the photoresist. Anti-reflective layer 108 is on the order of 300 - 5000Å (angstroms) thick. The preferred embodiment uses a thickness on the order of 550Å (angstroms). A layer of photoresist 110 is then deposited over anti-reflective layer 108.

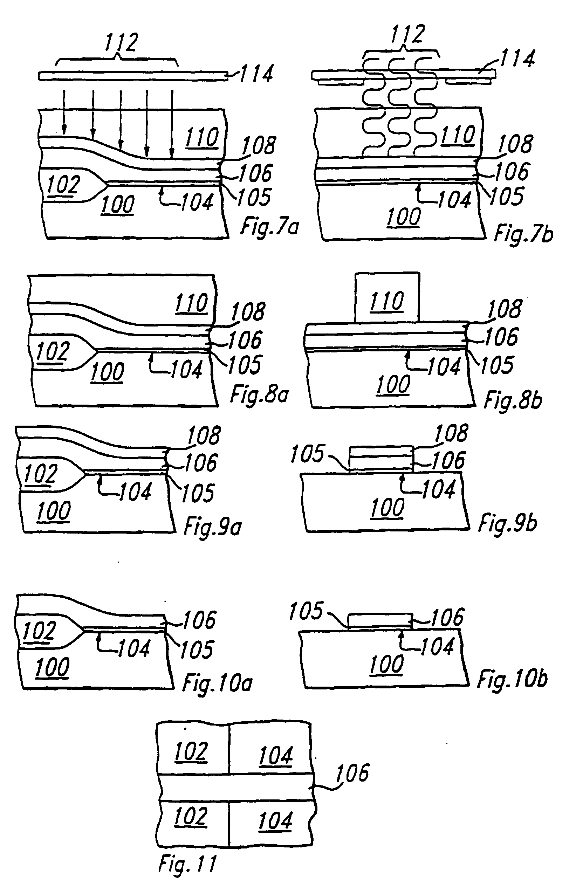

An optical beam 112 is then directed toward the structure through a reticle 114, as shown in Figures 7a-b. Anti-reflective layer 108 reduces the standing wave effects by absorbing the optical beam 112 instead of reflecting it. Accordingly, the interference pattern that occurs in the prior art is significantly reduced. Because anti-reflective coatings containing a metal such as titanium nitride have better light absorbing properties, the interference pattern is reduced even compared to organic anti-reflective coatings.

Optical beam 112 exposes the photoresist 110 in places not covered by reticle 114. The unexposed portions of photoresist are then removed as shown in Figures 8a-b. (Of course depending on whether positive or negative photoresist is used, the exposed photoresist could alternatively be removed. However, in that case, a different reticle would be used having a reversed pattern on it.) Methods for selectively removing unexposed photoresist are well known in the art.

Next, an anisotropic etch is performed to remove portions of anti-reflective layer 108 and polysilicon layer 106 that are not covered by photoresist 110 as shown in Figures 9a-b. Such etches are also well known in the art (e.g., a chlorine-based plasma etch). After the polysilicon etch and strip of photoresist 110, the anti-reflective coating 108 is removed as shown in Figures 10a-b. A wet etch may be used that does not attack the polysilicon or gate oxide. For example, a solution of ammonium hydroxide and hydrogen peroxide in water may be used. Other solutions, such as those used for stripping titanium nitride in a self-aligned salicidation process, may alternatively be used. Due to the reduction in standing wave effects, a more uniform polysilicon line 116 is created as shown in Figure 11. The variation in the width of polysilicon line 116 as it extends from field oxide regions 102 to moat regions 104 (i.e., changes in topography) is significantly reduced.

Conventional processing then continues to form source and drain regions to complete the transistors. Other elements and transistors may also be formed as well as interconnection between elements as is standard in the art.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

## Claims

1. A method for reducing the standing wave effects in a photolithography process of a polysilicon layer, comprising the steps of:
depositing an anti-reflective coating comprising a metal over said polysilicon layer;
depositing a layer of photoresist over said anti-reflective coating; and
exposing a first portion of said photoresist layer with an optical beam, wherein the standing wave effects are reduced by said anti-reflective coating absorbing said optical beam.

2. The method of claim 1, further comprising the steps of:
removing a second portion of said photoresist layer not exposed by said step of exposing said first portion of said photoresist layer; and
etching said anti-reflective coating and said polysilicon layer to create a polysilicon line having a uniform line width.

3. The method of claim 2, further comprising;
performing said etching step such that said polysilicon line extends over a field oxide region and a moat region.

4. The method of any preceding claim, further comprising;
removing said anti-reflective coating after said step of etching said anti-reflective coating and said polysilicon layer.

5. The method of any preceding claim, further comprising the steps of:
removing said first portion of said photoresist layer.

6. The method of any preceding claim, wherein said depositing step comprises;
depositing an anti-reflective coating comprising titanium nitride.

7. The method of any preceding claim, wherein said depositing step comprises;
depositing said anti-reflective coating to a thickness in the range of 300 to 5000 Å (angstroms).

8. The method of any preceding claim further comprising;
directing said optical beam through a reticle and onto said first portion of said photoresist layer.

9. The method any preceding claim, wherein said etching step comprises a wet etch that does not damage said polysilicon layer.

10. The method any preceding claim, wherein said removing step comprises the step of etching said titanium nitride layer with a solution of ammonium hydroxide and hydrogen peroxide and water.

11. A device fabricated according to the method of any of Claims 1 to 10.
